# EUROPEAN PATENT APPLICATION

(11) **EP 4 379 799 A1**
(43) Date of publication of application: **05.06.2024**
(21) Application number: 23207914.5
(22) Date of filing: 06.11.2023
(51) Int. Cl.: H01L 25/075, H01L 33/62, H01L 25/16, H01L 33/60

(54) **DISPLAY DEVICE**

(30) Priority: 29.11.2022 KR 20220162842
(71) Applicant: LG Display Co., Ltd., Seoul 07336 (KR)
(72) Inventor: NAM, Juhyun, Paju-si, Gyeonggi-do 10845 (KR); HA, YongMin, Paju-si, Gyeonggi-do 10845 (KR); LEE, BuYeol, Paju-si, Gyeonggi-do 10845 (KR); JANG, Hun, Paju-si, Gyeonggi-do 10845 (KR)
(74) Representative: Viering, Jentschura & Partner mbB Patent- und Rechtsanwälte

(57) **Abstract**

Provided is a display device (100). The display device (100) comprises a support substrate (121), a plurality of link lines (LL) disposed on the support substrate (121), a plurality of first flexible films (161) disposed on one side of the support substrate (121) and electrically connected to the plurality of link lines (LL), a plurality of display modules (110) disposed on or under the support substrate (121) and including a plurality of pixels (P) and a plurality of signal lines and a plurality of connection members (190) disposed between the support substrate (121) and the plurality of display modules (110) and electrically connecting the plurality of link lines (LL) and the plurality of signal lines. Therefore, A display device with a large screen can be provided.

## Description

### CROSS-REFERENCE TO RELATED APPLICATIONS

This application claims the benefit of and priority to Korean Patent Application No. 10-2022-0162842 filed on November 29, 2022, in the Republic of Korea.

### BACKGROUND

### Technical Field

The present disclosure relates to a display device, and more particularly, to a display device allowing for a reduction in a phenomenon in which a boundary between display modules adjacent to each other is visually recognized by a user, while implementing a large screen using a support substrate.

### Discussion of the Related Art

Liquid crystal display devices (LCDs) and organic light emitting display devices (OLEDs), which have been widely used up to now, are gradually expanding their application ranges.

Liquid crystal display devices and organic light emitting display devices are being widely applied to screens of usual electronic devices, such as mobile phones, laptop computers and the like, due to the advantages of being able to provide high resolution screens and allowing for thinning and weight reduction thereof, and an application range of the display devices is also gradually expanding.

However, in liquid crystal display devices and organic light emitting display devices, there is a limitation in reducing a size of a bezel area visible to a user, which is an area where an image is not displayed in the display device. For example, in the case of a liquid crystal display device, since a sealant needs to be used to seal liquid crystals and bond upper and lower substrates, there is a limit to reducing the size of the bezel area. In addition, in the case of an organic light emitting display device, since an organic light emitting element (LED) is formed of an organic material and is very vulnerable to moisture or oxygen, it is necessary to dispose an encapsulation for protecting the organic light emitting element (LED), so there is a limit to reducing the size of the bezel area. In particular, since it is not possible to implement an extra-large screen as a single panel, when a plurality of liquid crystal display panels or a plurality of organic light emitting display panels are disposed in a type of tile form to thereby implement an extra-large screen, a defect in which bezel areas between adjacent panels are visually recognized by a user can be caused.

As an alternative to this, a display device including LEDs has been proposed. Since the LED is formed of an inorganic material rather than an organic material, it has excellent reliability and has a longer lifespan compared to a liquid crystal display device or an organic light emitting display device. In addition, the LED is an element that is suitable for being applied to an extra-large screen because it has not only a fast-lighting speed, but also has low power consumption and excellent stability due to strong impact resistance, and can display high luminance images.

Accordingly, LED elements are generally used in a display device for providing an extra-large screen capable of minimizing a bezel area.

### SUMMARY

An object of the present disclosure is to provide a display device in which a boundary between display modules is not visually recognized, simultaneously with implementing a zero bezel.

Another object of the present disclosure is to provide a display device with a large screen.

Still another object of the present disclosure is to provide a display device suitable for a large transparent display device.

Objects of the present disclosure are not limited to the above-mentioned objects, and other objects, which are not mentioned above, can be clearly understood by those skilled in the art from the following descriptions.

According to an aspect of the present disclosure, there is provided a display device. The display device comprises a support substrate, a plurality of link lines disposed on the support substrate, a plurality of first flexible films disposed on one side of the support substrate and electrically connected to the plurality of link lines, a plurality of display modules disposed on or under the support substrate and including a plurality of pixels and a plurality of signal lines, and a plurality of connection members disposed between the support substrate and the plurality of display modules and electrically connecting the plurality of link lines and the plurality of signal lines. Therefore, a display device with a large screen can be provided. Further embodiments are described in the dependent claims.

Other detailed matters of exemplary embodiments are included in the detailed description and the drawings.

According to the present disclosure, a display device with a large screen can be implemented by disposing a plurality of display modules on a support substrate.

Also, according to the present disclosure, it is possible to prevent a boundary between a plurality of display modules from being visually recognized. Also, according to embodiments of the present disclosure, it is possible to provide a display device suitable for a large transparent display device since a boundary between display modules is not visually recognized.

In addition, according to the present disclosure, display devices having various sizes can be realized by freely disposing display modules.

In addition, according to the present disclosure, a plurality of link lines serve as auxiliary lines for signal lines of a plurality of display modules, so that a voltage drop in a display device can be prevented.

The effects according to the present disclosure are not limited to the contents exemplified above, and more various effects are included in the present specification.

### BRIEF DESCRIPTION OF THE DRAWINGS

FIG. 1 is a schematic plan view of a display device according to an exemplary embodiment of the present disclosure.
FIG. 2 is a schematic plan view of a support substrate of the display device according to an exemplary embodiment of the present disclosure.
FIG. 3 is a schematic plan view of a display module of the display device according to an exemplary embodiment of the present disclosure.
FIG. 4 is a schematic enlarged plan view of area A of FIG. 3.
FIG. 5 is a schematic enlarged plan view of area B of FIG. 3.
FIG. 6 is a cross-sectional view taken along VI-VI' of FIG. 5.
FIG. 7 is a schematic plan view of a display module of a display device according to another exemplary embodiment of the present disclosure.
FIG. 8 is a schematic plan view of a display module of a display device according to still another exemplary embodiment of the present disclosure.
FIG. 9 is a schematic cross-sectional view of a display device according to still another exemplary embodiment of the present disclosure.
FIG. 10 is a schematic plan view of a display device according to still another exemplary embodiment of the present disclosure.
FIG. 11 is a schematic plan view of a display device according to still another exemplary embodiment of the present disclosure.
FIG. 12 is a cross-sectional view taken along XII-XII' of FIG. 11.
FIG. 13 is a schematic plan view of a support substrate of a display device according to still another exemplary embodiment of the present disclosure.
FIG. 14 is a cross-sectional view of the display device according to still another exemplary embodiment of the present disclosure.

### DETAILED DESCRIPTION OF THE EMBODIMENTS

Advantages and characteristics of the present disclosure and a method of achieving the advantages and characteristics will be clear by referring to exemplary embodiments described below in detail together with the accompanying drawings. However, the present disclosure is not limited to the exemplary embodiments disclosed herein but will be implemented in various forms. The exemplary embodiments are provided by way of example only so that those skilled in the art can fully understand the disclosures of the present disclosure and the scope of the present disclosure. Therefore, the present disclosure will be defined only by the scope of the appended claims.

The shapes, sizes, ratios, angles, numbers, and the like illustrated in the accompanying drawings for describing the exemplary embodiments of the present disclosure are merely examples, and the present disclosure is not limited thereto. Like reference numerals generally denote like elements throughout the specification. Further, in the following description of the present disclosure, a detailed explanation of known related technologies may be omitted to avoid unnecessarily obscuring the subject matter of the present disclosure. The terms such as "including," "having," and "consist of" used herein are generally intended to allow other components to be added unless the terms are used with the term "only". Any references to singular may include plural unless expressly stated otherwise.

Components are interpreted to include an ordinary error range even if not expressly stated.

When the position relation between two parts is described using the terms such as "on", "above", "below", and "next", one or more parts may be positioned between the two parts unless the terms are used with the term "immediately" or "directly".

When an element or layer is disposed "on" another element or layer, another layer or another element may be interposed directly on the other element or therebetween.

Although the terms "first", "second", and the like are used for describing various components, these components are not confined by these terms. These terms are merely used for distinguishing one component from the other components. Therefore, a first component to be mentioned below may be a second component in a technical concept of the present disclosure.

Like reference numerals generally denote like elements throughout the specification.

A size and a thickness of each component illustrated in the drawing are illustrated for convenience of description, and the present disclosure is not limited to the size and the thickness of the component illustrated.

The features of various embodiments of the present disclosure can be partially or entirely adhered to or combined with each other and can be interlocked and operated in technically various ways, and the embodiments can be carried out independently of or in association with each other.

Hereinafter, a display device according to exemplary embodiments of the present disclosure will be described in detail with reference to accompanying drawings.

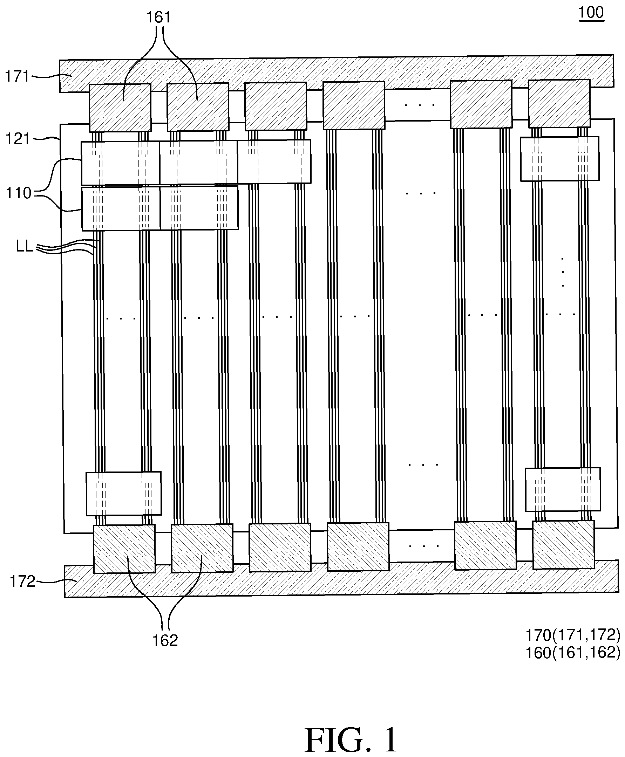

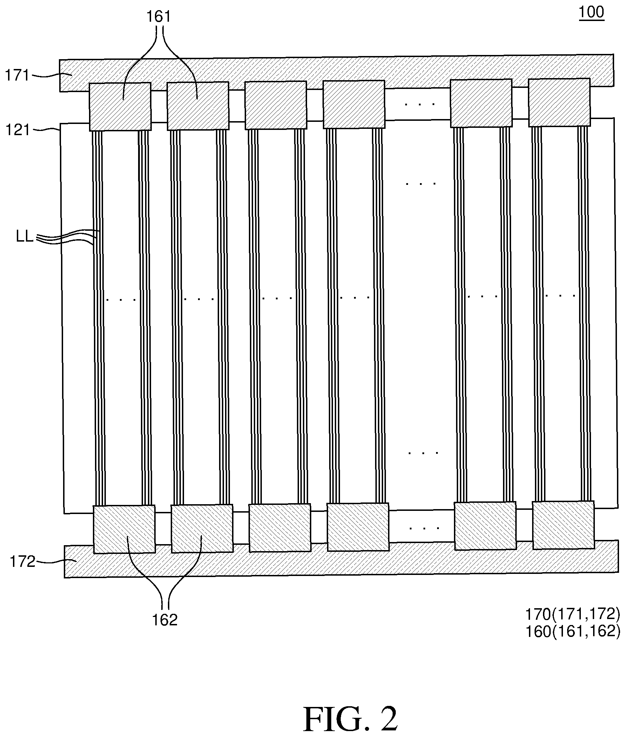

FIG. 1 is a schematic plan view of a display device according to an exemplary embodiment of the present disclosure. FIG. 2 is a schematic plan view of a support substrate of the display device according to an exemplary embodiment of the present disclosure. In FIG. 1, a support substrate 121, a plurality of link lines LL, a plurality of flexible films 160, printed circuit boards 170, and a plurality of display modules 110 among various components of a display device 100 are illustrated for convenience of description. FIG. 2 illustrates components other than the plurality of display modules 110 among components illustrated in FIG. 1.

Referring to FIGS. 1 and 2, the support substrate 121 is a substrate for supporting components disposed on the support substrate 121 and may be an insulating substrate. For example, the support substrate 121 may be formed of glass, resin or the like. Also, the support substrate 121 may be formed to include polymer or plastic.

The plurality of flexible films 160 may be disposed on the support substrate 121. The plurality of flexible films 160 may be electrically connected to the plurality of link lines LL. Also, the plurality of flexible films 160 may be bonded to the printed circuit boards 170 to transmit various signals from the printed circuit boards 170 to a plurality of pixels. For example, the plurality of flexible films 160 may supply high potential voltages, low potential voltages, scan signals, data signals and the like to the plurality of pixels through various lines disposed on the support substrate 121.

The plurality of flexible films 160 may include a plurality of first flexible films 161 and a plurality of second flexible films 162. The plurality of first flexible films 161 may be disposed on one side of the support substrate 121 and electrically connected to the plurality of link lines LL. The plurality of second flexible films 162 may be disposed on the other side opposite to the one side of the support substrate 121 and electrically connected to the plurality of link lines LL. Accordingly, the first flexible film 161 and the second flexible film 162 connected to the same one link line LL may apply the same signal to one link line.

The printed circuit boards 170 are connected to the plurality of flexible films 160. The printed circuit board 170 is a component that supplies a signal to a driver IC disposed on the flexible films 160. Various components for supplying various driving signals, such as data voltages and the like, to the driver IC may be disposed on the printed circuit boards 170.

The printed circuit boards 170 may include a first printed circuit board 171 and a second printed circuit board 172. The first printed circuit board 171 may be connected to the plurality of first flexible films 161 disposed on the one side of the support substrate 121. The second printed circuit board 172 may be connected to the plurality of second flexible films 162 disposed on the other side of the support substrate 121. Meanwhile, in FIGS. 1 and 2, it is illustrated that one first printed circuit board 171 and one second printed circuit board 172 are provided. However, the number of the first printed circuit boards 171 and the number of the second printed circuit boards 172 may be variously changed according to design, but the present disclosure is not limited thereto.

The plurality of link lines LL are disposed on the support substrate 121. Each of the plurality of link lines LL may transmit various signals and voltages from the flexible film 160 to a plurality of signal lines of the display module 110. Each of the plurality of link lines LL may be aligned and disposed in one direction on the support substrate 121 and electrically connected to one of the plurality of first flexible films 161 and one of the plurality of second flexible films 162.

The plurality of link lines LL may include a plurality of gate link lines, a plurality of data link lines, a plurality of high potential voltage link lines, a plurality of low potential voltage link lines, and a plurality of reference voltage link lines.

Each of the plurality of link lines LL may be connected to a plurality of signal lines disposed on a rear surface of the display module 110. Here, the plurality of signal lines may be a plurality of scan lines, a plurality of data lines, a plurality of high potential voltage lines, a plurality of low potential voltage lines, and a reference line, but are not limited thereto.

The plurality of gate link lines are lines for connecting the scan lines of the display module 110 and the flexible films 160, and the plurality of data link lines are lines for connecting the plurality of data lines of the display module 110 and the flexible films 160. Also, the plurality of high potential voltage link lines are lines for connecting the plurality of high potential voltage supply lines of the display module 110 and the flexible films 160. The plurality of low potential voltage link lines are lines for connecting the plurality of low potential voltage lines of the display module 110 and the flexible films 160. Also, the plurality of reference voltage link lines are lines for connecting the reference line of the display module 110 and the flexible films 160.

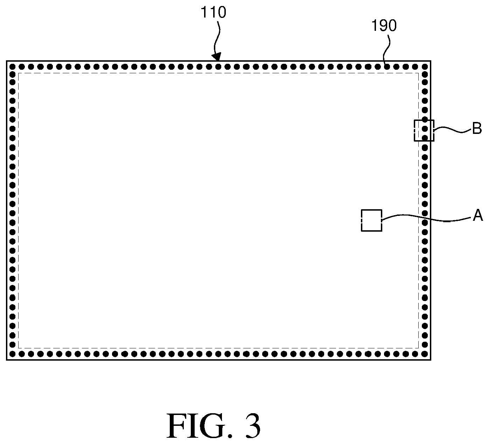

Referring to FIG. 1, the plurality of display modules 110 are disposed on the support substrate 121. The plurality of display modules 110 may be disposed in a tile form on the support substrate 121 to implement a tiling display. For example, the plurality of display modules 110 may be connected to the support substrate 121 through an electrical connection between the plurality of signal lines of the plurality of display modules 110 and the plurality of link lines LL disposed on the support substrate 121. In this case, all of the plurality of link lines LL may be disposed to overlap the plurality of display modules 110 without being exposed to the outside. Details of an electrical connection between the support substrate 121 and the plurality of display modules 110 will be described later with reference to FIGS. 3 to 6.

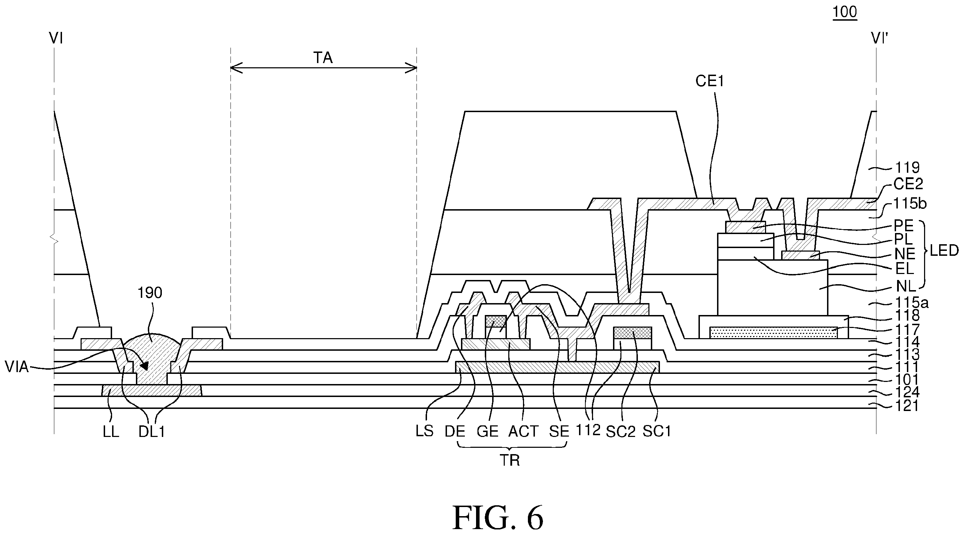

The display device 100 includes an active area. The plurality of pixels are defined in the active area. Each of the plurality of pixels is an individual unit that emits light, and the plurality of pixels may include a red pixel, a green pixel, and a blue pixel, but are not limited thereto. A transistor and a light emitting element are formed in each of the plurality of pixels. A more detailed description of the transistor and the light emitting element will be described later with reference to FIG. 6.

Meanwhile, when a tiling display is implemented using the display device 100 according to an exemplary embodiment of the present disclosure, the display device 100 may be defined as having no non-active area. That is, a distance between an outermost light emitting element of one display module and an outermost light emitting element of another display module adjacent thereto may be realized to be equal to a distance between light emitting elements within one display module. Accordingly, it is possible to implement a zero bezel in which a bezel area does not substantially exist. Accordingly, it may be described that the display device 100 is defined as having only the active area and a non-active area is not defined in the display device 100. Thus, the non-active area may be defined merely as an outer area.

Hereinafter, FIGS. 3 to 5 will be referred together for a more detailed description of the support substrate 121 and the plurality of display modules 110 of the display device 100.

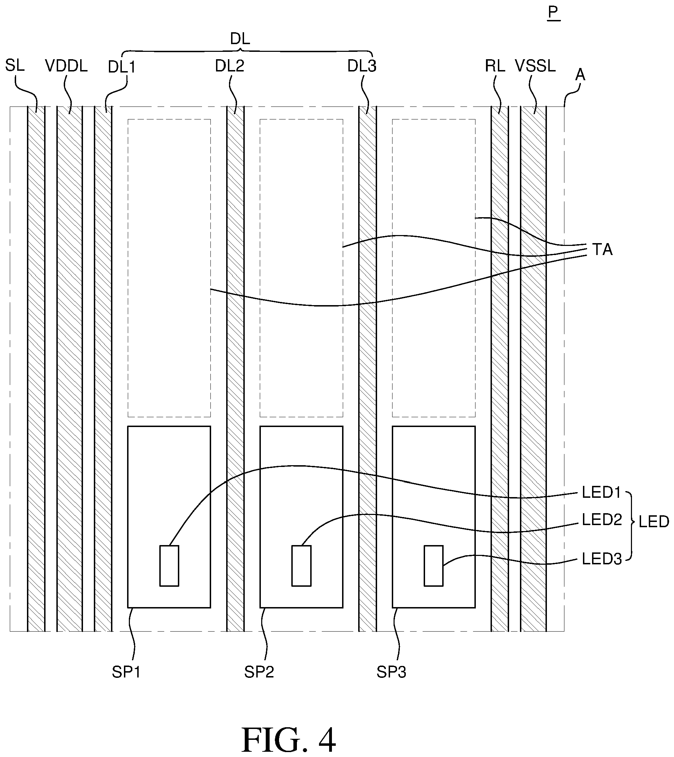

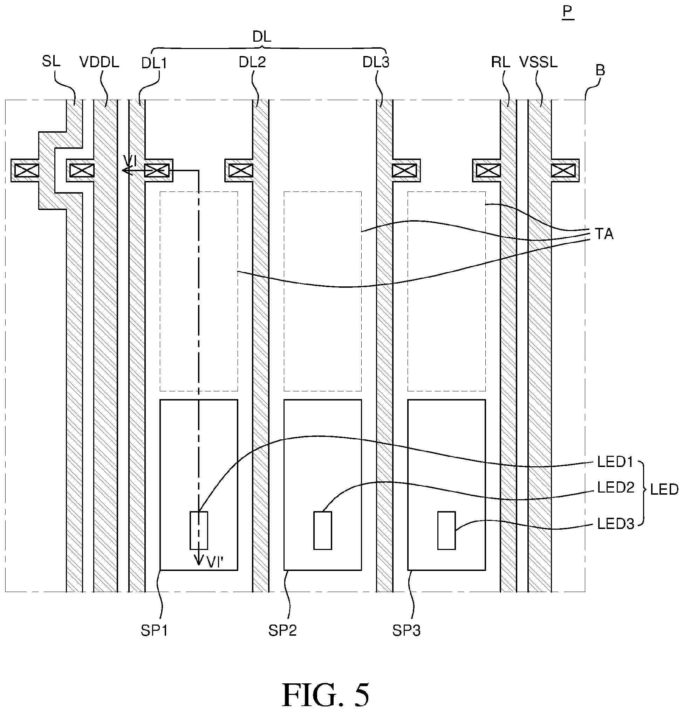

FIG. 3 is a schematic plan view of the display module of the display device according to an exemplary embodiment of the present disclosure. FIG. 4 is a schematic enlarged plan view of area A of FIG. 3. FIG. 5 is a schematic enlarged plan view of area B of FIG. 3. FIG. 6 is a cross-sectional view taken along VI-VI' of FIG. 5. FIG. 4 is an enlarged plan view of an area corresponding to a pixel P disposed in a central area of the display module 110. FIG. 5 is an enlarged plan view of an area corresponding to an outermost pixel P of the display module 110.

Referring to FIGS. 3 to 6, the display device 100 may include a plurality of connection members 190, a plurality of signal lines, a plurality of pixels P, and a plurality of light emitting elements LED.

The plurality of connection members 190 may be disposed in the display module 110.

The plurality of connection members 190 may be formed of a conductive material. For example, the plurality of connection members 190 may be formed from a metal layer, conductive ink, or conductive paste, and may be formed of a material such as silver paste. However, the present disclosure is not limited thereto.

The plurality of connection members 190 may be disposed to overlap the plurality of link lines LL of the support substrate 121. Accordingly, the connection members 190 may electrically connect the plurality of link lines LL disposed on the support substrate 121 and the signal lines connected to the pixel P of the display module 110.

Referring to FIG. 3, the plurality of connection members 190 may be disposed along an outer area of the display module 110. Specifically, the plurality of connection members 190 are disposed in an area where they overlap outermost pixels P among the plurality of pixels P of the display module 110, and may connect the plurality of signal lines connected to the outermost pixels P and the plurality of link lines LL. Accordingly, the plurality of connection members 190 may be electrically connected to the plurality of signal lines in the area overlapping the outermost pixels P among the plurality of pixels P. On the other hand, referring to FIGS. 3 and 4, the plurality of connection members 190 may not be disposed in an area corresponding to the pixel P in the central portion of the display panel 110.

Referring to FIG. 3, the plurality of connection members 190 are disposed in areas of the display panel 110 where they overlap the plurality of pixels P disposed in a first row and the plurality of pixels P disposed in a last row. In addition, the plurality of connection members 190 are disposed in areas of the display panel 110 where they overlap the plurality of pixels P disposed in a leftmost column and the plurality of pixels P disposed in a rightmost column. Accordingly, the plurality of signal lines that are disposed in the plurality of pixels P disposed in the first row, the plurality of pixels P disposed in the last row, the plurality of pixels P disposed in the leftmost column, and the plurality of pixels P disposed in the rightmost column directly receive signals from the plurality of link lines LL through the plurality of connection members 190.

Meanwhile, the signal lines that are not disposed in the pixels disposed in the first row, the last row, the leftmost column, and the rightmost column may indirectly receive signals from the plurality of link lines LL. Specifically, the plurality of signal lines extend in a column direction in the display module 110. Accordingly, the plurality of signal lines in the pixels P disposed in the first row and the last row directly receive signals from the plurality of link lines LL through the plurality of connection members 190. In addition, in the case of pixels P disposed between the pixels P disposed in the first row and the pixels P disposed in the last row, the plurality of signal lines in a first row and a last row thereof receive signals. Accordingly, if there is only one connection between the link line LL and the signal line in one column of the pixels P, all of the pixels P disposed in the corresponding column can be driven.

Referring to FIGS. 4 and 5, the plurality of display modules 110 include the plurality of signal lines and the plurality of pixels P.

The plurality of pixels P may include first sub-pixels SP1, second sub-pixels SP2, and third sub-pixels SP3. The first sub-pixel SP1, the second sub-pixel SP2, and the third sub-pixel SP3 may be sub-pixels emitting different colors. For example, the first sub-pixel SP1, the second sub-pixel SP2, and the third sub-pixel SP3 are a red sub-pixel emitting red light, a green sub-pixel emitting green light, and a blue sub-pixel emitting blue light, respectively. However, the present disclosure is not limited thereto. For example, the plurality of pixels P may further include a white sub-pixel emitting white light.

Each of the plurality of sub-pixels SP1, SP2, and SP3 may include a light emitting area and a circuit area. The light emitting area may be defined as an emission area where light emitted from the light emitting element LED may travel to the outside. The light emitting area is an area capable of independently emitting light of one color, and the light emitting element LED may be disposed therein. For example, a first light emitting element LED1 emitting red light may be disposed in the first sub-pixel SP1, and a second light emitting element LED2 emitting green light may be disposed in the second sub-pixel SP2. and a third light emitting element LED3 emitting blue light may be disposed in the third sub-pixel SP3.

The circuit area is the area excluding the light emitting area, and driving circuits for driving the plurality of light emitting elements LED may be disposed therein. For example, a driving circuit including a transistor TR and a storage capacitor SC may be disposed in the circuit area.

Meanwhile, transmissive areas TA may be disposed in the plurality of pixels P. The transmissive area TA is an area in which a reflective material is not disposed, and may be an area in which various insulating layers are disposed. Accordingly, the display device 100 according to an exemplary embodiment of the present disclosure may be a transparent display device in which transmittance is secured through the transmissive area TA, so that objects disposed on a rear surface of the display device 100 can be visually recognized when the display device 100 is viewed from a front of the display device 100. However, the present disclosure is not limited thereto.

The plurality of signal lines are disposed on a substrate SUS. The plurality of signal lines are lines that transmit various signals to the driving circuit, such as scan lines SL, data lines DL, high potential supply voltage lines VDDL, reference lines RL and low potential voltage lines VSSL.

The data lines DL are lines that transmit data signals to each of the sub-pixels SP1, SP2, and SP3. A plurality of the data lines DL are disposed to extend in the column direction between the plurality of sub-pixels SP1, SP2, and SP3, and may include a first data line DL1, a second data line DL2, and a third data line DL3. The first data line DL1, the second data line DL2, and the third data line DL3 may transfer data voltages to the respective sub-pixels SP1, SP2, and SP3. For example, the first data line DL1 can transfer data voltages to the first sub-pixel SP1, the second data line DL2 can transfer data voltages to the second sub-pixel SP2, and the third data line DL3 may transfer data voltages to the third sub-pixel SP3.

A plurality of the high potential power supply lines VDDL are lines that transfer a high potential power supply voltage to each of the plurality of sub-pixels SP1, SP2, and SP3. The plurality of high potential power supply lines VDDL may extend in the column direction.

The plurality of sub-pixels SP1, SP2, and SP3 may share one high potential power supply line VDDL. For example, one high potential power supply line VDDL may be disposed between the first sub-pixel SP1 and the third sub-pixel SP3 and supply a high potential power supply voltage to each of the first sub-pixel SP1, the second sub-pixel SP2, and the third sub-pixels SP3.

A plurality of the reference lines RL are lines extending in the column direction to transfer a reference voltage to each of the plurality of sub-pixels SP1, SP2, and SP3. The plurality of sub-pixels SP1, SP2, and SP3 may share one reference line RL. For example, one reference line RL may be disposed between the third sub-pixel SP3 and the first sub-pixel SP1 and transfer a reference voltage to each of the first sub-pixel SP1, the second sub-pixel SP2, and the third sub-pixels SP3.

The low potential voltage line VSSL is a line for applying a low potential voltage to the plurality of pixels P. The low potential voltage line VSSL may extend in the column direction. The sub-pixels SP1, SP2, and SP3 may share one low potential voltage line VSSL. For example, one low potential voltage line VSSL is disposed between the first sub-pixel SP1 and the third sub-pixel SP3 and may supply a low potential power supply voltage to each of the first sub-pixel SP1, the second sub-pixel SP2, and the third sub-pixels SP3.

The scan line SL is a line for transmitting a scan signal to each of the plurality of pixels P. The scan line SL may be disposed in the column direction in which the data lines DL extend, and may extend in a row direction different from the direction of the data line DL and cross the data line DL.

Hereinafter, FIG. 6 will be referred for a more detailed description of the plurality of signal lines of the display device 100 and various components of the display module 110.

Referring to FIG. 6 together with the drawings, the substrate 101 may be disposed under the plurality of display modules 110. The substrate 101 may be disposed to support various components disposed on the display module 110.

The substrate 101 may be an insulating substrate formed of glass, resin or the like. In addition, the substrate 101 may be formed to include a polymer or plastic.

A plurality of signal lines are disposed on the substrate 101. The plurality of signal lines may include a plurality of scan lines SL, a plurality of high potential power supply lines VDDL, a plurality of data lines DL, and a plurality of reference lines RL. In FIG. 6, a first data line DL1 among the plurality of signal lines is illustrated for convenience of description.

Referring to FIG. 6, a light blocking layer LS is disposed on the substrate 101. The light blocking layer LS may be disposed on the substrate 101.

The light blocking layer LS may be disposed to overlap an active layer ACT of the transistor TR to block light which is incident to the active layer ACT. If the active layer ACT is irradiated with light, since leakage current is generated, reliability of the transistor TR, which is a driving transistor, may be lowered. In this case, when the light blocking layer LS formed of an opaque conductive material such as copper (Cu), aluminum (Al), molybdenum (Mo), nickel (Ni), titanium (Ti), chromium (Cr) or an alloy thereof is disposed to overlap the active layer ACT, light which is incident from a lower portion of the display module 110 to the active layer ACT can be blocked, so that reliability of the transistor TR can be improved.

Meanwhile, although the light blocking layer LS is illustrated as being a single layer in the drawings, the light blocking layer LS may be formed of a plurality of layers. For example, the light blocking layer LS may include a plurality of layers disposed to overlap each other with at least one of a buffer layer 111, a gate insulating layer 112, and an interlayer insulating layer 113 interposed therebetween.

The buffer layer 111 is disposed on the substrate 101 and the light blocking layer LS. The buffer layer 111 may reduce penetration of moisture or impurities through the substrate 101. For example, the buffer layer 111 may be formed of a single layer or multiple layers of silicon oxide (SiOx) or silicon nitride (SiNx), but is not limited thereto. In addition, the buffer layer 111 may be omitted depending on a type of substrate 101 or a type of transistor TR, but is not limited thereto.

The transistor TR is disposed on the buffer layer 111 in each of the plurality of sub-pixels SP1, SP2, and SP3.

The transistor TR includes the active layer ACT, a gate electrode GE, a source electrode SE, and a drain electrode DE.

The active layer ACT is disposed on the buffer layer 111. The active layer ACT may be formed of a semiconductor material such as an oxide semiconductor, amorphous silicon, or polysilicon, but is not limited thereto. For example, when the active layer ACT is formed of an oxide semiconductor, the active layer ACT includes a channel region, a source region, and a drain region, and the source area and the drain region may be conductive regions, but are limited thereto.

The gate insulating layer 112 is disposed on the active layer ACT. The gate insulating layer 112 is a layer for insulating the gate electrode GE and the active layer ACT, and may be formed of an insulating material. For example, the gate insulating layer 112 may be formed of a single layer or multiple layers of silicon oxide (SiOx) or silicon nitride (SiNx), but is not limited thereto.

The gate insulating layer 112 and the gate electrode GE may be formed in the same pattern, but the present disclosure is not limited thereto. The gate insulating layer 112 may be formed on an entire surface of the substrate 101.

The gate electrode GE is disposed on the gate insulating layer 112. The gate electrode GE may be disposed to overlap the gate insulating layer 112, and the gate electrode GE may be formed of a conductive material such as copper (Cu), aluminum (Al), molybdenum (Mo), nickel (Ni), titanium (Ti), chromium (Cr), or an alloy thereof, but is not limited thereto.

The interlayer insulating layer 113 is disposed on the gate electrode GE and the buffer layer 111. The interlayer insulating layer 113 is a layer for insulating the gate electrode GE, the source electrode SE, and the drain electrode DE, and may be formed of an inorganic material, similarly to the gate insulating layer 112. For example, the interlayer insulating layer 113 may be formed of a single layer or multiple layers of silicon oxide (SiOx) or silicon nitride (SiNx), but is not limited thereto.

The source electrode SE and the drain electrode DE are disposed on the interlayer insulating layer 113 to be spaced apart from each other. The source electrode SE and the drain electrode DE may be electrically connected to the active layer ACT through via holes formed in the interlayer insulating layer 113. The source electrode SE and the drain electrode DE may be disposed on the same layer as the gate electrode GE and formed of the same conductive material, but the present disclosure is not limited thereto. For example, the source electrode SE and the drain electrode DE may be formed of copper (Cu), aluminum (Al), molybdenum (Mo), nickel (Ni), titanium (Ti), chromium (Cr), or an alloy thereof, but is not limited thereto.

The drain electrode DE is electrically connected to the high potential power supply line VDDL. For example, the drain electrodes DE of the second sub-pixel SP2 and the third sub-pixel SP3 may be electrically connected to the high potential power supply line VDDL on a left side of the first sub-pixel SP1.

The source electrode SE may be electrically connected to the light blocking layer LS through a via hole formed in the interlayer insulating layer 113 and the buffer layer 111. If the light blocking layer LS is floating, a threshold voltage or the like of the transistor TR may change, which may affect driving of the display device 100. Accordingly, a voltage may be applied to the light blocking layer LS by electrically connecting the light blocking layer LS to the source electrode SE, and driving of the transistor TR may not be affected thereby. However, the present disclosure is not limited thereto, and both the active layer ACT and the source electrode SE may directly contact the light blocking layer LS.

A plurality of signal lines may be disposed on the interlayer insulating layer 113. For example, the plurality of signal lines may include a plurality of scan lines SL, a plurality of high potential power supply lines VDDL, a plurality of data lines DL, and a plurality of reference lines RL, but the present disclosure is not limited thereto. The plurality of signal lines may be disposed on the same layer on the substrate 101 and formed of a common conductive material. The plurality of scan lines SL, the plurality of high potential power supply lines VDDL, the plurality of data lines DL, and the plurality of reference lines RL may be formed of a conductive material such as copper (Cu), aluminum (Al), molybdenum (Mo), nickel (Ni), titanium (Ti), chromium (Cr) or an alloy thereof, but the present disclosure is not limited thereto. However, the plurality of signal lines may be disposed on different layers on the substrate 101 and formed of different conductive materials. Also, the plurality of signal lines may be formed of the same material as the drain electrode DE and the source electrode SE. Meanwhile, the plurality of signal lines may be disposed on different layers on the substrate 101 and may be formed of different conductive materials. In this case, each of the plurality of signal lines may be formed of the same material on the same layer as any one of components constituting the transistor TR.

The storage capacitor SC is disposed in the circuit area of each of the plurality of sub-pixels SP1, SP2, and SP3. The storage capacitor SC may store a voltage between the gate electrode GE and the source electrode SE of the transistor TR so that the light emitting element LED continuously maintains the same state during one frame. The storage capacitor SC includes a first capacitor electrode SC1 and a second capacitor electrode SC2.

The first capacitor electrode SC1 is disposed between the substrate 101 and the buffer layer 111 in each of the plurality of sub-pixels SP. The first capacitor electrode SC1 may be disposed closest to the substrate 101, among conductive components disposed on the substrate 101. The first capacitor electrode SC1 may be integrally formed with the light blocking layer LS, and may be electrically connected to the source electrode SE through the light blocking layer LS.

The buffer layer 111 and the gate insulating layer 112 are disposed on the first capacitor electrode SC1, and the second capacitor electrode SC2 is disposed on the buffer layer 111 and the gate insulating layer 112. The second capacitor electrode SC2 may be disposed to overlap the first capacitor electrode SC1. The second capacitor electrode SC2 may be formed of the same material as the gate electrode GE. For example, a semiconductor material may be formed on the gate insulating layer 112 and a portion of the semiconductor material may be patterned to form the gate electrode GE and the second capacitor electrode SC2.

A passivation layer 114 is disposed on the transistor TR and the storage capacitor SC. The passivation layer 114 is an insulating layer for protecting components under the passivation layer 114. For example, the passivation layer 114 may be composed of a single layer or multiple layers of silicon oxide (SiOx) or silicon nitride (SiNx), but is not limited thereto. Also, the passivation layer 114 may be omitted according to embodiments.

A plurality of reflective layers 117 are disposed on the passivation layer 114. The reflective layer 117 is disposed to overlap the light emitting area including the light emitting element LED. The reflective layer 117 may reflect light incident from the light emitting element LED, upwardly of the light emitting element LED, thereby improving light efficiency of the display device 100. Accordingly, a low-power display device may be implemented. However, when the display device 100 is a bottom emission type, the reflective layer 117 may be omitted or disposed above the light emitting element LED.

An adhesive layer 118 covering the reflective layer 117 is disposed on the reflective layer 117. The adhesive layer 118 is an adhesive layer 118 for bonding the light emitting element LED onto the reflective layer 117, and may insulate the reflective layer 117 formed of a metal material from the light emitting element LED. The adhesive layer 118 may be formed of a heat curable material or a photocurable material, but is not limited thereto. In FIG. 6, the adhesive layer 118 is illustrated as being disposed to cover only the reflective layer 117, but an arrangement position of the adhesive layer 118 is not limited thereto.

The plurality of light emitting elements LED are disposed on the adhesive layer 118. The plurality of light emitting elements LED are disposed to overlap the plurality of reflective layers 117. The plurality of light emitting elements LED include an n-type layer NL, an active layer EL, a p-type layer PL, an n-electrode NE, and a p-electrode PE. Hereinafter, it will be described that the light emitting element LED having a lateral structure is used as the light emitting element LED, but the structure of the light emitting element LED is not limited thereto.

Specifically, the n-type layer NL of the light emitting element LED is disposed on the adhesive layer 118. The n-type layer NL may be formed by implanting n-type impurities into gallium nitride having excellent crystallinity. The active layer EL is disposed on the n-type layer NL. The active layer EL is a light emitting layer that emits light from the light emitting element LED, and may be formed of a nitride semiconductor, for example, indium gallium nitride. The p-type layer PL is disposed on the active layer EL. The p-type layer PL may be formed by implanting p-type impurities into gallium nitride. However, materials constituting the n-type layer NL, the active layer EL, and the p-type layer PL are not limited thereto.

The p-electrode PE is disposed on the p-type layer PL of the light emitting element LED. In addition, the n-electrode NE is disposed on the n-type layer NL of the light emitting element LED. The n-electrode NE is disposed to be spaced apart from the p-electrode PE. Specifically, the light emitting element LED may be manufactured by a method of sequentially stacking the n-type layer NL, the active layer EL, and the p-type layer PL, etching a predetermined portion of the active layer EL and the p-type layer PL, and forming the electrode NE and the p-electrode PE. In this case, the predetermined portion is a space for separating the n-electrode NE and the p-electrode PE, and the predetermined portion may be etched to expose a portion of the n-type layer NL. In other words, surfaces of the light emitting element LED on which the n-electrode NE and the p-electrode PE are disposed may have different height rather than being a flattened surface. Accordingly, the p-electrode PE is disposed on the p-type layer PL, the n-electrode NE is disposed on the n-type layer NL, and the p-electrode PE and the n-electrode NE are disposed at different height to be spaced apart from each other. Accordingly, the n-electrode NE may be disposed adjacent to the adhesive layer 118 compared to the p-electrode PE. Also, the n-electrode NE and the p-electrode PE may be formed of a conductive material, for example, a transparent conductive oxide. In addition, the n-electrode NE and the p-electrode PE may be formed of the same material, but are not limited thereto.

A first planarization layer 115a is disposed on the transistor TR. The first planarization layer 115a may be disposed to planarize an upper surface of the transistor TR in an area other than an area where the light emitting element LED is disposed.

The first planarization layer 115a may be formed of an organic material, and may be composed of a single layer or multiple layers of, for example, polyimide or photoacryl, but is not limited thereto.

A second planarization layer 115b is disposed on the first planarization layer 115a and the light emitting element LED. The second planarization layer 115b is a layer for planarizing upper surfaces of the transistor TR and the light emitting element LED. Although FIG. 6 illustrates that the first planarization layer 115a and the second planarization layer 115b are disposed, the present disclosure is not limited thereto, and one planarization layer may be formed. When one planarization layer is disposed, an excessive increase in time required for a process can be prevented. Also, the planarization layer may be composed of two or more layers. The second planarization layer 115b may be formed of the same material as the first planarization layer 115a, but is not limited thereto.

A first electrode CE1 is an electrode electrically connecting the transistor TR and the light emitting element LED. The first electrode CE1 is connected to the p-electrode PE of the light emitting element LED through a via hole formed in the second planarization layer 115b. In addition, the first electrode CE1 is connected to the source electrode SE of the transistor TR through a via hole formed in the planarization layers 115a and 115b and the passivation layer 114. However, the present disclosure is not limited thereto, and the first electrode CE1 may be connected to the drain electrode DE of the transistor TR according to a type of the transistor TR.

A second electrode CE2 is an electrode electrically connecting the light emitting element LED and the low potential voltage line VSSL. Specifically, the second electrode CE2 is connected to the low potential voltage line VSSL through the via hole formed in the planarization layers 115a and 115b and the passivation layer 114, and is connected to the n-electrode NE of the light emitting element LED through the via hole formed in the second planarization layer 115b. Therefore, the low potential voltage line VSSL and the n-electrode NE of the light emitting element LED are electrically connected.

A bank 119 is disposed on the second planarization layer 115b, the first electrode CE1 and the second electrode CE2. The bank 119 is an insulating layer defining the light emitting area. The bank 119 may be formed of an organic insulating material, and may be formed of the same material as the planarization layers 115a and 115b. In addition, the bank 119 may be configured to include a black material to prevent a color mixing phenomenon from occurring as light emitted from the light emitting element LED is transmitted to the sub-pixels SP1, SP2, and SP3 adjacent thereto.

The transmissive area TA may be disposed in an area other than the transistor TR, the storage capacitor SC, and the light emitting element LED. The transmissive area TA is an area in which a reflective material is not disposed in components constituting the transistor TR, the storage capacitor SC, and the light emitting element LED, and may be an area in which various insulating layers are disposed. In addition, a portion of various insulating layers may be removed in the transmissive area TA to secure transmittance in the transmissive area. For example, the planarization layers 115a and 115b and the bank 119 may not be disposed in the transmissive area TA, but the present disclosure is not limited thereto.

Referring to FIG. 6, a plurality of via holes VIA may be disposed in an area adjacent to the transmissive area TA in the display module 110. The via holes VIA may be formed to expose the plurality of signal lines such as the first data lines DL1 and the plurality of link lines LL disposed under the substrate 101. Accordingly, the via holes VIA may be formed to pass through components of the display module 110 disposed between the plurality of link lines LL and the first data lines DL1. For example, the via holes VIA may be formed to pass through the substrate 101, the buffer layer 111, the gate insulating layer 112, and the interlayer insulating layer 113, but the present disclosure is not limited thereto.

The plurality of via holes VIA may be disposed along the outer area of the display module 110 and may be disposed in an area overlapping outermost pixels P among the plurality of pixels P of the display module 110.

The plurality of connection members 190 may be disposed in the plurality of via holes VIA of the display module 110. The plurality of connection members 190 may fill inner portions of the plurality of via holes VIA. The plurality of connection members 190 may contact the plurality of link lines LL and the first data lines DL 1. Accordingly, the plurality of connection members 190 may connect the plurality of link lines LL and the first data lines DL1 in the outermost pixels P of the display module 110. Meanwhile, since the link line LL is connected to the first data line DL1 in FIG. 6, the link line LL illustrated in FIG. 6 may be a data link line among the plurality of link lines LL.

The connection member 190 may be formed of a conductive material. For example, the connection member 190 may be formed of a material such as a metal layer, conductive ink, or silver paste, but is not limited thereto. Accordingly, the plurality of connection members 190 may electrically connect the first data lines DL1 and the plurality of link lines LL in the outer area of the display module 110.

The connection member 190 may be applied onto the inner portion of the via hole VIA through a printing process such as a nozzle method, a slit coating method, or an ink-jet method. Therefore, by printing the connection member 190 in a large area, process optimization can be implemented in a process of forming the connection member 190. Meanwhile, a shape of the connection members 190 is not limited as long as it connects the plurality of link lines LL and the first data lines DL1. For example, an upper surface of the connection member 190 may be disposed to protrude upwardly from the passivation layer 114, and the connection member 190 may be disposed along surfaces of the via hole VIA and the first data line DL1. For example, when the connection member 190 is formed through a thin film deposition method such as PVD, the connection member 190 may be disposed on the upper surface of the via hole VIA to have a uniform thickness. Accordingly, the connection member 190 may be disposed along the surface of the via hole VIA.

Meanwhile, in FIG. 6, for convenience, it is illustrated that the plurality of connection members 190 connect the link lines LL and the first data lines DL1 among the plurality of signal lines, but the plurality of connection members 190 may electrically connect other signal lines and other link lines in other areas.

Referring to FIG. 6, the plurality of link lines LL and a filling member 124 may be disposed on the support substrate 121. The filling member 124 may be disposed between the support substrate 121 and the plurality of display modules 110. The filling member 124 may be disposed between the support substrate 121 and the display module 110 in an area where the plurality of link lines LL are not disposed. That is, the filling member 124 may fill spaces between the plurality of display modules 110 and the support substrate 121 between the plurality of link lines LL.

The filling member 124 may be formed of a material having the same refractive index as that of the support substrate 121. Accordingly, the filling member 124 may serve as a refractive index matching layer between the plurality of link lines LL. If a material filling a space between the plurality of link lines is not disposed on the support substrate, a boundary between the display modules may be visually recognized, and display quality may be degraded. Therefore, by disposing the filling member 124 having the same refractive index as that of the support substrate 121, it is possible to prevent an area between the plurality of display modules from being visually recognized by a user.

In a typical tiling display device according to the prior art, side lines formed of a metal material such as silver (Ag) are disposed on a side surface of a display module to connect lines disposed on an upper portion of the display module to lines disposed on a lower portion of the display module. In this case, when the side line is formed of a metal material, external light is reflected from the side line or light emitted from the light emitting element is reflected from the side line, so that the light can be visually recognized from the outside. Thus, a black insulating layer formed of a black material is disposed to cover the side line, so that it is possible to prevent light from being visually recognized from the outside. However, since the side line and the black insulating layer have a predetermined thickness, a boundary between display modules on which the black insulating layer is disposed can be visually recognized by a user, thereby causing a sense of disconnection in a displayed image. In particular, when the tiling display device is implemented as a transparent display device, the sense of disconnection described above is maximized, so a boundary between display modules may be more clearly, visually recognized by the user.

In addition, a printed circuit board for driving the display module is disposed on one side of the plurality of display modules. The printed circuit board may be disposed on the same plane as the display module, or may be disposed to be bent to a rear surface of the display module. However, another display module cannot be disposed on the one side of the display module on which the printed circuit board is disposed. Accordingly, since there is a limitation in disposing the display modules in a process of tiling a plurality of display modules, it is difficult to implement free tiling of a display device.

Accordingly, in the display device 100 according to an exemplary embodiment of the present disclosure, a separate support substrate 121 is disposed under the plurality of display modules 110, and the plurality of link lines LL are disposed on the support substrate 121. In addition, the plurality of signal lines disposed on the plurality of display modules 110 are not connected to the plurality of link lines LL through the side lines on the side surfaces of the plurality of display modules 110, and are connected to the plurality of link lines LL by the connection members 190 disposed to overlap the plurality of display modules 110. Therefore, in the display device 100 according to an exemplary embodiment of the present disclosure, the plurality of connection members 190 and the plurality of via holes VIA are disposed in an area corresponding to an outer portion of the display panel 110, so that the connection members 190 are not disposed in an area where they do not overlap the display module 110. Thus, other components may not be disposed in a space between the plurality of display modules 110 that are tiled. Therefore, in the display device 100 according to an exemplary embodiment of the present disclosure, it is possible to prevent a boundary between the display modules 110 from being visually recognized. In particular, when the display device 100 is implemented as a transparent display device, transparency of the display device 100 can be secured.

In addition, in the display device 100 according to an exemplary embodiment of the present disclosure, the tiling display device 100 is implemented in a manner that the flexible films 160 and the printed circuit boards 170 are disposed on the support substrate 121, the plurality of link lines LL are directly disposed on the support substrate 121, and the plurality of display modules 110 are disposed on the support substrate 121. Therefore, in the display device 100 according to an exemplary embodiment of the present disclosure, since the number and arrangement of the display modules 110 may be freely adjusted by securing a size of the support substrate 121 according to a size of the tiling display device 100, so a large display device 100 can be implemented.

In addition, in the display device 100 according to an exemplary embodiment of the present disclosure, since the plurality of display modules 110 are disposed on the support substrate 121, the plurality of display modules 110 can be freely detachable from the support substrate 121. Accordingly, in the display device 100 according to an exemplary embodiment of the present disclosure, when a defect occurs in a specific display module, only the defective display module can be separated from the support substrate 121 and replaced, thereby facilitating a repair process.

In addition, in the display device 100 according to an exemplary embodiment of the present disclosure, the plurality of link lines LL disposed on the support substrate 121 may serve as auxiliary lines of the signal lines disposed on the display module 110. That is, the plurality of link lines LL are connected to the plurality of signal lines of the display panel 110 through the connection members 190, so that the plurality of link lines LL and the plurality of signal lines may be connected in parallel. Therefore, in the display device 100 according to an exemplary embodiment of the present disclosure, since resistance of the plurality of signal lines can be lowered, signal delay such as RC delay can be prevented, and degradation in luminance uniformity due to voltage drop can be prevented. Accordingly, a low-power and high-luminance display device can be implemented.

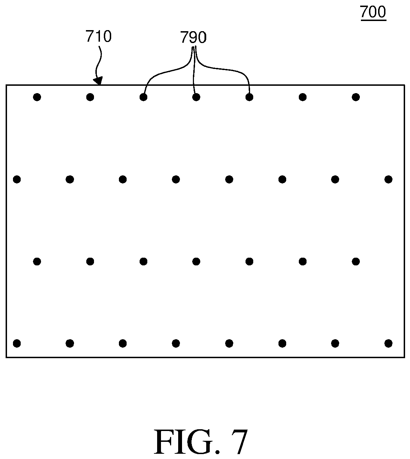

FIG. 7 is a schematic plan view of a display module of a display device according to another exemplary embodiment of the present disclosure. Since other configurations of a display device 700 of FIG. 7 are substantially identical to those of the display device 100 of FIGS. 1 to 6 except that the display device 700 has a difference in terms of a plurality of connection members 790, redundant descriptions thereof will be omitted. In FIG. 7, only a display module 710 and the plurality of connection members 790 among various components constituting the display device 700 are illustrated for convenience of description.

Referring to FIG. 7, the plurality of connection members 790 are disposed on the display module 710. The plurality of connection members 790 may be disposed to overlap the plurality of link lines LL of the support substrate 121.

The plurality of connection members 790 may be regularly arranged over an entire area of the plurality of pixels P disposed in an outer area and a central area of the display module 710. For example, the plurality of connection members 790 may be electrically connected to the plurality of signal lines in an area where they overlap some pixels among the plurality of pixels P of the display module 710. For example, each of the connection members 790 may be electrically connected to the plurality of signal lines in an area overlapping one of the pixels P disposed in a 2x2 array or one of the pixels P disposed in a 4x4 array. Accordingly, the plurality of connection members 790 are not concentrated in a specific area but may be periodically disposed over an entire area of the display module 710 and connect the plurality of signal lines and the plurality of link lines LL to each other.

Meanwhile, the number and positions of the plurality of connection members 790 illustrated in FIG. 7 are merely examples and may be variously changed according to design, and the present disclosure is not limited thereto.

In the display device 700 according to another exemplary embodiment of the present disclosure, the separate support substrate 121 is disposed under the plurality of display modules 710, and the plurality of link lines LL are disposed on the support substrate 121. Therefore, in the display device 700 according to another exemplary embodiment of the present disclosure, since the plurality of connection members 790 and the plurality of via holes VIA are disposed to overlap the display module 710, it is possible to prevent a boundary between the display modules 710 from being visually recognized, and transparency of the display device 700 can be secured.

In addition, in the display device 700 according to another exemplary embodiment of the present disclosure, since the number and arrangement of the display modules 710 may be freely adjusted by securing the size of the support substrate 121 according to a size of the tiling display device 700, so a large display device 700 can be implemented.

In addition, in the display device 700 according to another exemplary embodiment of the present disclosure, when a defect occurs in a specific display module, only the defective display module can be separated from the support substrate 121 and replaced, thereby facilitating a repair process.

In addition, in the display device 700 according to another exemplary embodiment of the present disclosure, the plurality of link lines LL disposed on the support substrate 121 may serve as auxiliary lines of the signal lines disposed on the display module 710. Therefore, signal delay such as RC delay can be prevented, and degradation in luminance uniformity due to voltage drop can be prevented.

In addition, in the display device 700 according to another exemplary embodiment of the present disclosure, the plurality of connection members 790 are not concentrated in a specific area, but are periodically disposed in the entire area of the display module 710 and reduce a difference in transparency. For example, when the plurality of connection members are concentrated in a specific area, transparency in the area where the connection members are concentrated may be significantly lowered compared to an area where the connection members are not disposed. Accordingly, a variance in transparency of the display device may be visually recognized by the user, thereby causing a sense of disconnection in a displayed image. Therefore, in the display device 700 according to another exemplary embodiment of the present disclosure, the plurality of connection members 790 are regularly disposed at predetermined intervals over the entire area of the display module 710, so that it is possible to prevent a defect in which a difference in transparency of the display device 700 may be visually recognized by a user.

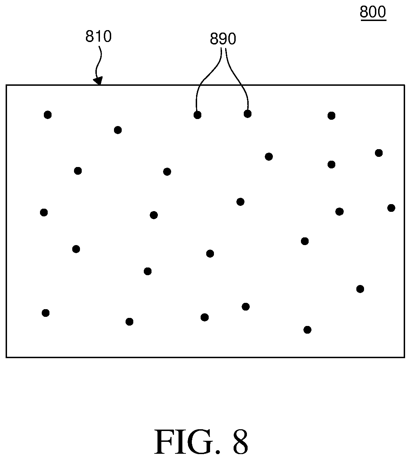

FIG. 8 is a schematic plan view of a display module of a display device according to still another exemplary embodiment of the present disclosure. Since other configurations of a display device 800 of FIG. 8 are substantially identical to those of the display device 100 of FIGS. 1 to 6 except the display device 800 has a difference in terms of a plurality of connection members 890, redundant descriptions thereof will be omitted. In FIG. 8, only a display module 810 and a plurality of connection members 890 among various components constituting the display device 800 are illustrated for convenience of description.

Referring to FIG. 8, the plurality of connection members 890 are disposed on the display module 810. The plurality of connection members 890 may be disposed to overlap the plurality of link lines LL of the support substrate 121.

Referring to FIG. 8, the plurality of connection members 890 may be disposed in an area where they randomly overlap some pixels of the plurality of pixels P. That is, the plurality of connection members 890 may be disposed to be spaced apart from each other at irregular intervals over the entire area of the pixels P disposed in an outer area and a central area of the display module 810. Accordingly, the plurality of connection members 890 may be randomly disposed over an entire area of the display module 810 and connect the plurality of signal lines and the plurality of link lines LL to each other.

In the display device 800 according to still another exemplary embodiment of the present disclosure, the separate support substrate 121 is disposed under a plurality of display modules 810, and the plurality of link lines LL are disposed on the support substrate 121. Therefore, in the display device 800 according to still another exemplary embodiment of the present disclosure, since the plurality of connection members 890 and the plurality of via holes VIA are disposed to overlap the display module 810, it is possible to prevent a boundary between the display modules 810 from being visually recognized, and transparency of the display device 800 can be secured.

In addition, in the display device 800 according to still another exemplary embodiment of the present disclosure, since the number and arrangement of the display modules 810 may be freely adjusted by securing the size of the support substrate 121 according to a size of the tiling display device 800, so a large display device 800 can be implemented.

In addition, in the display device 800 according to still another exemplary embodiment of the present disclosure, when a defect occurs in a specific display module, only the defective display module can be separated from the support substrate 121 and replaced, thereby facilitating a repair process.

In addition, in the display device 800 according to still another exemplary embodiment of the present disclosure, the plurality of link lines LL disposed on the support substrate 121 may serve as auxiliary lines of the signal lines disposed on the display module 810. Therefore, signal delay such as RC delay can be prevented, and degradation in luminance uniformity due to voltage drop can be prevented.

In addition, in the display device 800 according to still another exemplary embodiment of the present disclosure, the plurality of connection members 890 may be randomly disposed over an entire area of the display module 810 and reduce a difference in transparency of the display device. For example, when the plurality of connection members are disposed according to a specific rule, regular arrangement of the connection members may be visually recognized by a user. Accordingly, a difference in transparency of the display device may be visually recognized by the user, thereby causing a sense of disconnection in a displayed image. Therefore, in the display device 800 according to still another exemplary embodiment of the present disclosure, the plurality of connection members 890 are randomly disposed in the entire area of the display module 810, so that it is possible to prevent a defect in which a difference in transparency of the display device 800 may be visually recognized by a user.

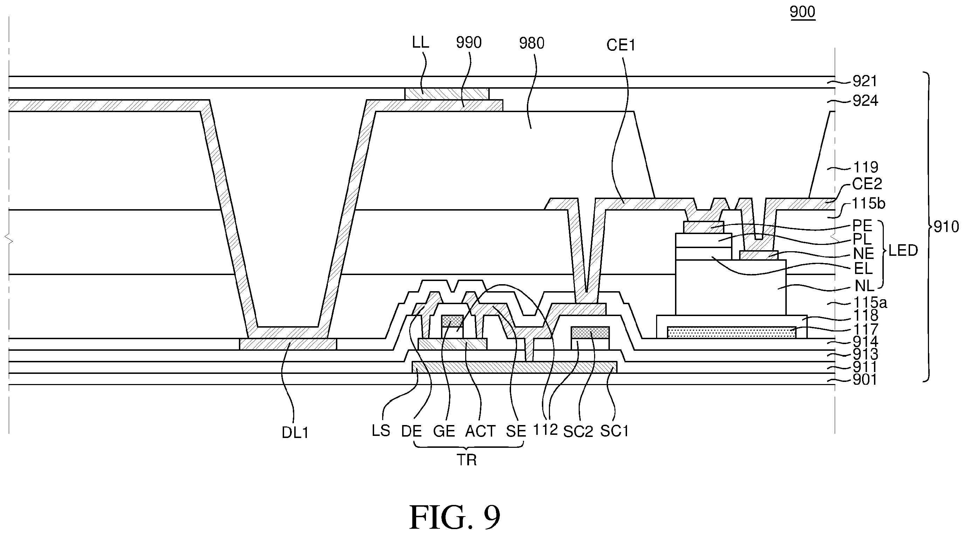

FIG. 9 is a schematic cross-sectional view of a display device according to still another exemplary embodiment of the present disclosure. Other configurations of a display device 900 of FIG. 9 are substantially identical to those of the display device 100 of FIGS. 1 to 6, except that a plurality of via holes are not disposed in display modules 910 and the display device 900 includes a step portion 980 and has differences in terms of a support substrate 921 and a plurality of connection members 990. Thus, redundant descriptions thereof will be omitted.

Referring to FIG. 9, a filling member 924, a plurality of link lines LL, and the support substrate 921 are disposed on a plurality of the display modules 910.

The filling member 924 may be disposed on the plurality of light emitting elements LED, the second planarization layer 115b, and the first data lines DL1 that are disposed on the plurality of display modules 910, and may planarize upper surfaces of the plurality of display modules 910. Between the support substrate 921 and the plurality of display modules 910, the filling member 924 may fill a space between the support substrate 921 and the plurality of display modules 910, and may fill a space between the plurality of link lines LL.

The filling member 924 may be formed of a material having the same refractive index as that of the support substrate 921. Accordingly, the filling member 924 may serve as a refractive index matching layer between the plurality of link lines LL.

The support substrate 921 may be disposed on the plurality of display modules 910, the filling member 924, and the plurality of link lines LL to provide strong protection against external impacts and scratches.

Referring to FIG. 9, the display module 910 is disposed below the support substrate 921.

A buffer layer 911, an interlayer insulating layer 913, and a passivation layer 914 are disposed on a substrate 901 of the display module 910. The buffer layer 911, the interlayer insulating layer 913, and the passivation layer 914 may be disposed on the substrate 901 while filling an inside of the display module 910 without a separate via hole.

The planarization layers 115a and 115b and a plurality of step portions 980 are disposed on the passivation layer 914. The plurality of step portions 980 may be disposed on the planarization layers 115a and 115b to connect the plurality of connection members 990 and the plurality of link lines LL. Accordingly, upper surfaces of the plurality of step portions 980 may be disposed at a height corresponding to the plurality of link lines LL and may have a flat shape. The step portions 980 may be formed to overlap the plurality of link lines LL disposed on a rear surface of the support substrate 921.

The plurality of step portions 980 may be disposed in an area overlapping outermost pixels P among the plurality of pixels P of the display module 910. However, the present disclosure is not limited thereto, and the plurality of step portions 980 may be irregularly arranged over an entire area of the pixels P disposed in an outer area and a central area of the display module 910, or may be randomly disposed in an area overlapping some of the pixels P.

The plurality of step portions 980 may be formed of an organic insulating material, and may be formed of the same material as the planarization layers 115a and 115b. In addition, the plurality of step portions 980 may be configured to include a black material in order to prevent a color mixing phenomenon from occurring as light emitted from the light emitting element LED is transmitted to the sub-pixels SP1, SP2, and SP3 adjacent thereto. Accordingly, in the display device 900 according to still another exemplary embodiment of the present disclosure, a separate bank is not disposed, and the plurality of step portions 980 may serve as the bank.

However, the present disclosure is not limited thereto, and a bank for preventing a color mixing phenomenon may be additionally disposed on the planarization layers 115a and 115b.

The plurality of connection members 990 may be disposed on the step portions 980 and the second planarization layer 115b. The plurality of connection members 990 may be disposed to cover upper surfaces and side surfaces of the step portions 980. In this case, the plurality of connection members 990 may contact the plurality of link lines LL on the upper surfaces of the step portions 980. The connection members 990 may be formed of a conductive material, for example, may be formed of a metal layer, but the present disclosure is not limited thereto.

Also, the plurality of connection members 990 may contact the first data lines DL1. The plurality of connection members 990 may be connected to a plurality of signal lines of the display module 910. Accordingly, the plurality of connection members 990 may electrically connect the first data lines DL1 and the plurality of link lines LL. In FIG. 9, for convenience, it is illustrated that the plurality of connection members 190 connect the link lines LL and the first data lines DL1 among the plurality of signal lines. However, the plurality of connection members 990 may electrically connect other signal lines and other link lines in other areas.

Accordingly, in the display device 900 according to still another exemplary embodiment of the present disclosure, a separate support substrate 921 is disposed on the plurality of display modules 910, and the plurality of link lines LL are disposed on the support substrate 921. Therefore, in the display device 900 according to still another exemplary embodiment of the present disclosure, since the plurality of connection members 990 are disposed to overlap the display module 910, it is possible to prevent a boundary between the display modules 910 from being visually recognized, and transparency of the display device 900 can be secured.

In addition, in the display device 900 according to still another exemplary embodiment of the present disclosure, since the number and arrangement of the display modules 910 may be freely adjusted by securing a size of the support substrate 921 according to a size of the tiling display device 900, so a large display device 900 can be implemented.

In the display device 900 according to still another exemplary embodiment of the present disclosure, when a defect occurs in a specific display module, only the defective display module can be separated from the support substrate 921 and replaced, thereby facilitating a repair process.

In addition, in the display device 900 according to still another exemplary embodiment of the present disclosure, the plurality of link lines LL disposed on the support substrate 921 serve as auxiliary lines of the signal lines disposed on the display module 910. Therefore, signal delay such as RC delay can be prevented, and degradation in luminance uniformity due to voltage drop can be prevented.

In addition, in the display device 900 according to still another exemplary embodiment of the present disclosure, the support substrate 921 is disposed on the plurality of modules 910, contact areas of the plurality of connection members 990 may be secured, regardless of a thickness of the substrate 901 of the plurality of display modules 910. For example, when the connection member is disposed in a direction passing through a thickness of the substrate of the display module, a variance in difficulty of a process for forming a via hole may change depending on the thickness of the substrate. On the other hand, in the display device 900 according to still another exemplary embodiment of the present disclosure, the plurality of connection members 990 may be disposed on the step portions 980 to electrically connect the plurality of signal lines and the plurality of link lines LL of the support substrate 921 without forming a via hole. Accordingly, the connection members 990 may be formed without process variations, and contact areas of the plurality of signal lines and the plurality of link lines LL of the support substrate 921 may be stably secured.

In addition, in the display device 900 according to still another exemplary embodiment of the present disclosure, the step portions 980 disposed to connect the plurality of connection members 990 and the plurality of link lines LL may be disposed on top portions of the display modules 910. Accordingly, a degree of freedom in design of the step portion 980 and the connection member 990 may be improved. For example, when the connection member is disposed in the direction passing through the thickness of the substrate of the display module, an area in which the connection member can be disposed is limited. On the other hand, in the display device 900 according to still another exemplary embodiment of the present disclosure, the plurality of step portions 980 and the plurality of connection members 990 may be disposed in transmissive areas TA, and may be disposed to overlap a plurality of transistors TR. Accordingly, in the display device 900 according to still another exemplary embodiment of the present disclosure, the plurality of step portions 980 and the plurality of connection members 990 may be freely disposed according to design. Meanwhile, when the plurality of step portions 980 and the plurality of connection members 990 are disposed to overlap the plurality of transistors TR, the connection members 990 may not be disposed in the transmissive areas TA. Accordingly, in the display device 900 according to still another exemplary embodiment of the present disclosure, a decrease in transparency in the transmissive area TA can be prevented.

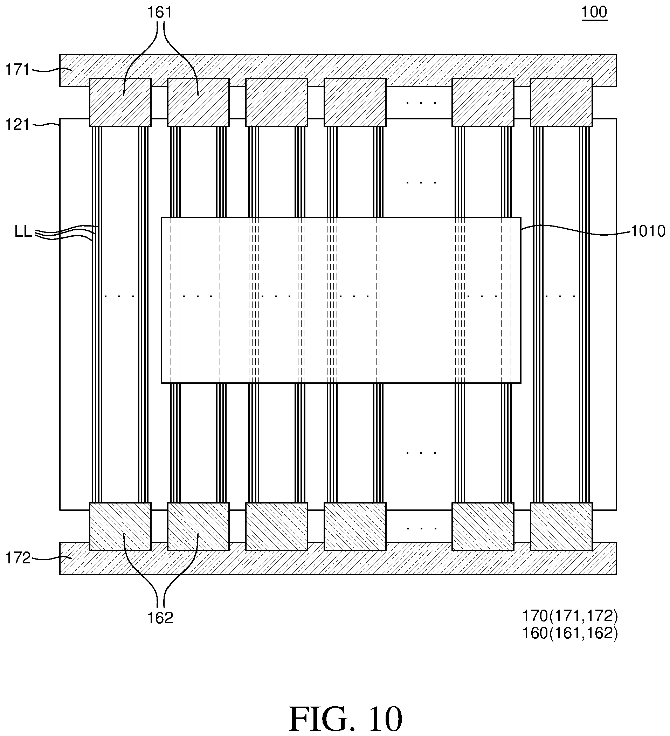

FIG. 10 is a schematic plan view of a display device according to still another exemplary embodiment of the present disclosure. Since other configurations of a display device 1000 of FIG. 10 are substantially identical to those of the display device 100 of FIGS. 1 to 6 except that the display device 1000 has differences in terms of a plurality of link lines LL and a display module 1010, redundant descriptions thereof will be omitted.

Referring to FIG. 10, the plurality of link lines LL and the display module 1010 are disposed on the support substrate 121.

A plurality of signal lines of the display module 1010 and the plurality of link lines LL disposed on the support substrate 121 may be connected electrically connected.

Referring to FIG. 10, the display module 1010 may be disposed to overlap only a partial area on the support substrate 121. For example, the display module 1010 may not cover an entire area of the support substrate 121. Accordingly, the display module 1010 may be disposed to overlap a portion of the plurality of link lines LL, and another portion of the plurality of link lines LL may be exposed by the display module 1010.

Meanwhile, the display module 1010 is illustrated as being disposed in a central portion of the support substrate 121, but the present disclosure is not limited thereto, and the display module 1010 may be disposed in various positions of the support substrate 121. For example, the display module 1010 may be biased on one side of the support substrate 121. In addition, although FIG. 10 illustrates that a single display module 1010 is disposed on the support substrate 121, the present disclosure is not limited thereto, and a plurality of display modules 1010 may be disposed to overlap a portion of the plurality of link lines LL, and another portion of the plurality of link lines LL may be exposed by the plurality of display modules 1010.

Meanwhile, although not illustrated in FIG. 10, an insulating layer may be disposed on the support substrate 121. The insulating layer may cover a portion of the plurality of link lines LL to prevent the plurality of link lines LL from being exposed to the outside and being corroded or damaged.

In the display device 1000 according to still another exemplary embodiment of the present disclosure, the separate support substrate 121 is disposed under the plurality of display modules 1010, and the plurality of link lines LL are disposed on the support substrate 121. Therefore, in the display device 1000 according to still another exemplary embodiment of the present disclosure, since the plurality of connection members 190 and the plurality of via holes VIA are disposed to overlap the display module 1010, it is possible to prevent a boundary between the display modules 1010 from being visually recognized, and transparency of the display device 1000 can be secured.

In addition, in the display device 1000 according to still another exemplary embodiment of the present disclosure, the plurality of link lines LL disposed on the support substrate 121 may serve as auxiliary lines of the signal lines disposed on the display module 1010. Therefore, signal delay such as RC delay can be prevented, and degradation in luminance uniformity due to voltage drop can be prevented.

In addition, in the display device 1000 according to still another exemplary embodiment of the present disclosure, the plurality of link lines LL disposed on the support substrate 121 may serve as auxiliary lines of the signal lines disposed in the display module 1010. Therefore, signal delay such as RC delay can be prevented, and luminance uniformity deterioration due to voltage drop can be prevented.

Also, in the display device 1000 according to still another exemplary embodiment of the present disclosure, the plurality of display modules 1010 may be disposed independently of the size of the support substrate 121. For example, the plurality of display modules 1010 may be disposed only on a partial area of the supporting substrate 121 so that the other area of the supporting substrate 121 may be exposed. Accordingly, the area of the support substrate 121 in which the plurality of display modules 1010 are not disposed may be used as a transparent area. Specifically, the area of the support substrate 121 on which the display modules 1010 are not disposed may function as a transparent screen allowing objects disposed on a rear surface of the display device 1000 to be viewed together. For example, the display device 1000 can be used as an exhibition stand in a museum so that exhibits displayed on the rear surface of the display module 1010 and information on the exhibits disposed on the display module 1010 can be simultaneously viewed. Accordingly, the display device 1000 according to still another exemplary embodiment of the present disclosure may provide various aesthetic effects and functional effects according to arrangement positions of the display modules 1010.

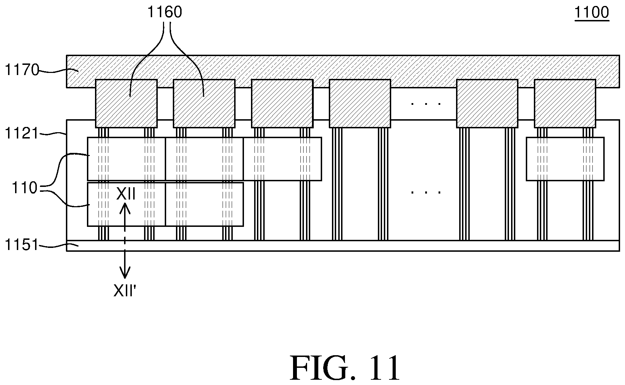

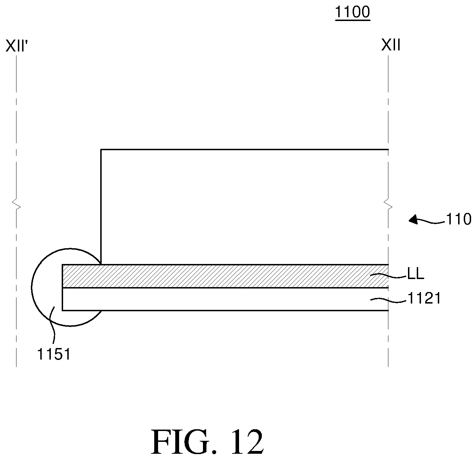

FIG. 11 is a schematic plan view of a display device according to still another exemplary embodiment of the present disclosure. FIG. 12 is a cross-sectional view taken along XII-XII' of FIG. 11. Other configurations of a display device 1100 of FIG. 11 are substantially identical to those of the display device 100 of FIGS. 1 to 6 except that the display device 1100 has differences in terms of a support substrate 1121, flexible films 1160, a printed circuit board 1170, a plurality of link lines LL, and a plurality of display modules 1110, and an end protection member 1151 is added. Thus, redundant descriptions will be omitted.

Referring to FIG. 11, a plurality of the flexible films 1160 and the printed circuit board 1170 may be disposed on the support substrate 1121. The plurality of flexible films 1160 may be disposed on one side of the support substrate 1121 and electrically connected to the plurality of link lines LL.

The plurality of link lines LL are disposed to extend from the plurality of flexible films 1160 to the other side opposite to one side of the support substrate 1121.

Referring to FIGS. 11 and 12, end portions of the plurality of link lines LL extending from the flexible film 1160 may be disposed on the same plane as an end portion of the support substrate 1121 on the other side of the support substrate 1121.

Referring to FIGS. 11 and 12, the end protection member 1151 may be disposed on the other side of the support substrate 1121. The end protection member 1151 may be formed of an insulating material. For example, the end protection member 1151 may be formed of an organic insulating material, but is not limited thereto.

The end protection member 1151 may cover the end portions of the plurality of link lines LL and the end portion of the support substrate 1121. For example, the end protection member 1151 may be disposed to cover a portion of the upper surfaces of the plurality of link lines LL together with a portion of an upper surface and a lower surface of the support substrate 1121 and a side surface of the support substrate 1121. Thus, the end protection member 1151 may protect the support substrate 1121 from external impacts and can prevent penetration of external moisture and oxygen from side surfaces of the plurality of link lines LL. In addition, the end protection member 1151 is formed of an insulating material and may prevent electrical shorting of the plurality of link lines LL on the other side of the support substrate 1121. Meanwhile, in FIG. 12, the end protection member 1151 is illustrated as having a circular shape in cross-section, but the present disclosure is not limited thereto, and the end protection member 1151 may be disposed in various shapes in cross-section.

In the display device 1100 according to still another exemplary embodiment of the present disclosure, a separate support substrate 1121 is disposed below the plurality of display modules 1110, and the plurality of link lines LL are disposed on the support substrate 1211. Therefore, in the display device 1100 according to still another exemplary embodiment of the present disclosure, since the plurality of connection members 190 and the plurality of via holes VIA are disposed to overlap the display module 1110, it is possible to prevent a boundary between the display modules 1110 from being visually recognized, and transparency of the display device 1100 can be secured.

In addition, in the display device 1100 according to still another exemplary embodiment of the present disclosure, when a defect occurs in a specific display module, only the defective display module can be separated from the support substrate 1121 and replaced, thereby facilitating a repair process.

In addition, in the display device 1100 according to still another exemplary embodiment of the present disclosure, the plurality of link lines LL disposed on the support substrate 1121 may serve as auxiliary lines of the signal lines disposed on the display module 1110. Therefore, signal delay such as RC delay can be prevented, and degradation in luminance uniformity due to voltage drop can be prevented.

In addition, in the display device 1100 according to still another exemplary embodiment of the present disclosure, a size of the display device 1100 can be changed variously according to design, so that a customized product can be easily formed. Specifically, in the display device 1100 according to still another exemplary embodiment of the present disclosure, a plurality of display devices 1100 may be formed by cutting a large support substrate. For example, in the case of manufacturing a display device having a size smaller than that of the support substrate to which flexible films can be attached to both sides thereof, the size of the support substrate can be adjusted by cutting a specific area thereof. In this manner, when the support substrate is cut, since a plurality of link lines are cut along with the support substrate, the plurality of link lines may be disposed to extend up to an end portion of the support substrate. Accordingly, a signal applied from the flexible film may be transmitted to a display module disposed at the end portion of the support substrate, so there may be a defect in driving a plurality of display modules. Therefore, in the display device 1100 according to still another exemplary embodiment of the present disclosure, a customized display device can be implemented simply by cutting the support substrate into a customized size.

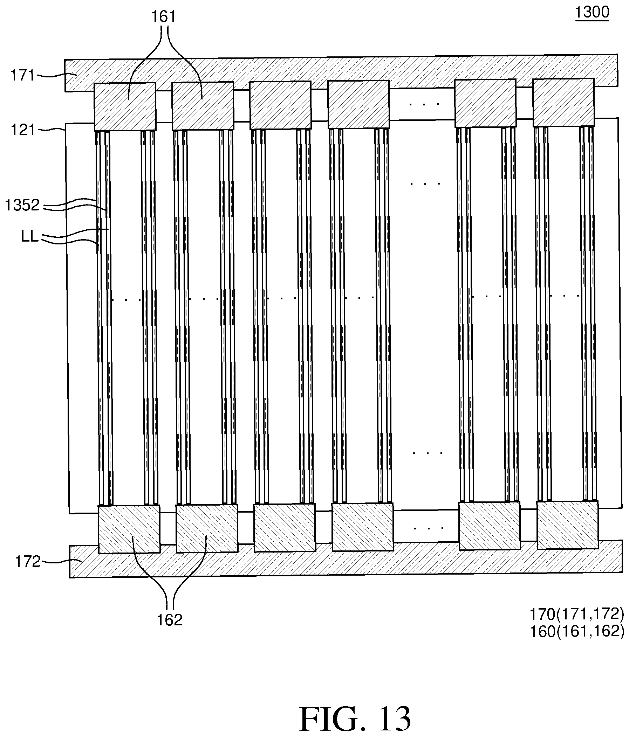

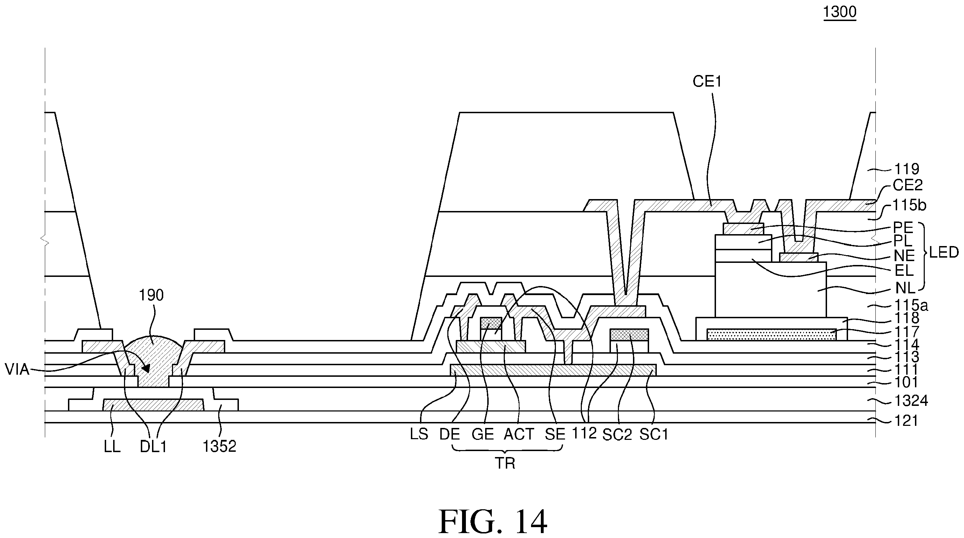

FIG. 13 is a schematic plan view of a support substrate of a display device according to still another exemplary embodiment of the present disclosure. FIG. 14 is a cross-sectional view of the display device according to still another exemplary embodiment of the present disclosure. FIG. 13 illustrates components of a display device 1300 except for the plurality of display modules 110. Since other configurations of the display device 1300 of FIGS. 13 and 14 are substantially identical to those of the display device 100 of FIGS. 1 to 6 except that anti-corrosion patterns 1352 are added, redundant descriptions thereof will be omitted.

Referring to FIGS. 13 and 14, a plurality of the anti-corrosion patterns 1352 are disposed on the support substrate 121. The plurality of anti-corrosion patterns 1352 are disposed on the support substrate 121 to cover the plurality of link lines LL. Accordingly, the plurality of anti-corrosion patterns 1352 may cover upper surfaces and side surfaces of the plurality of link lines LL that are exposed. That is, the anti-corrosion pattern 1352 may be disposed to cover each of the link lines LL.

The plurality of anti-corrosion patterns 1352 may be formed of a material having corrosion resistance and may be formed of a transparent conductive material. For example, the plurality of anti-corrosion patterns 1352 may be formed of indium tin oxide (ITO), but the present disclosure is not limited thereto.

A filling member 1324 may be disposed between the plurality of link lines LL and the plurality of anti-corrosion patterns 1352. The filling member 1324 may be disposed between adjacent anti-corrosion patterns among the plurality of anti-corrosion patterns 1352 to fill a space between the plurality of anti-corrosion patterns 1352. In addition, the filling member 1324 may be disposed between the support substrate 121 and the plurality of display modules 110 and have a flat upper surface so that the plurality of display modules 110 may be disposed on the support substrate 121.

Accordingly, in the display device 1300 according to still another exemplary embodiment of the present disclosure, the separate support substrate 121 is disposed under the plurality of display modules 110, and the plurality of link lines LL are disposed on the support substrate 121. Therefore, in the display device 1300 according to still another exemplary embodiment of the present disclosure, since the plurality of connection members 190 and the plurality of via holes VIA are disposed to overlap the display module 110, it is possible to prevent a boundary between the display modules 110 from being visually recognized, and transparency of the display device 1300 can be secured.

In addition, in the display device 1300 according to still another exemplary embodiment of the present disclosure, since the number and arrangement of the display modules 110 may be freely adjusted by securing the size of the support substrate 121 according to a size of the tiling display device 1300, so a large display device 1300 can be implemented.

In addition, in the display device 1300 according to still another exemplary embodiment of the present disclosure, when a defect occurs in a specific display module, only the defective display module can be separated from the support substrate 121 and replaced, thereby facilitating a repair process.

In addition, in the display device 1300 according to still another exemplary embodiment of the present disclosure, the plurality of link lines LL disposed on the support substrate 121 may serve as auxiliary lines of the signal lines disposed on the display module 110. Therefore, signal delay such as RC delay can be prevented, and degradation in luminance uniformity due to voltage drop can be prevented.

In addition, in the display device 1300 according to still another exemplary embodiment of the present disclosure, the plurality of anti-corrosion patterns 1352 may cover each of the plurality of link lines LL. Accordingly, it is possible to prevent a defect in which the plurality of link lines LL disposed on the support substrate 121 are exposed and corroded. In the display device 1300, since a single link line is connected to a plurality of display modules, corrosion of the link line may cause a defect in driving the plurality of display modules. Accordingly, in the display device 1300 according to still another exemplary embodiment of the present disclosure, a material having corrosion resistance is disposed on the plurality of link lines LL and may prevent the plurality of link lines LL from being exposed to the outside and corrosion of the plurality of link lines LL. Accordingly, stability of the display device 1300 can be improved. In addition, transparency of the display device 1300 can be secured by configuring the plurality of anti-corrosion patterns 1352 with a material having transparency.

Exemplary embodiments of the present disclosure can also be described as follows:

According to an aspect of the present disclosure, there is provided a display device. The display device comprises a support substrate, a plurality of link lines disposed on the support substrate, a plurality of first flexible films disposed on one side of the support substrate and electrically connected to the plurality of link lines, a plurality of display modules disposed on or under the support substrate and including a plurality of pixels and a plurality of signal lines and a plurality of connection members disposed between the support substrate and the plurality of display modules and electrically connecting the plurality of link lines and the plurality of signal lines.

The display device may further comprise a plurality of second flexible films disposed on the other side of the support substrate. The one side of the support substrate and the other side of the support substrate may be opposite sides of the support substrate.

Each of the plurality of link lines may be electrically connected to one of the plurality of first flexible films and one of the plurality of second flexible films.

The plurality of connection members may be electrically connected to the plurality of signal lines in an area where they overlap outermost pixels among the plurality of pixels.

The plurality of connection members may be electrically connected to the plurality of signal lines in an area in which they overlap some pixels among the plurality of pixels of the display modules.

The plurality of connection members may be electrically connected to the plurality of signal lines in an area where they randomly overlap some pixels among the plurality of pixels.

The plurality of display modules may be disposed on the support substrate, the plurality of display modules may include a plurality of via holes, and the plurality of connection members may be disposed in the plurality of via holes and may be in contact with the plurality of link lines and the plurality of signal lines.

The support substrate may be disposed on the plurality of display modules, the plurality of display modules may include step portions for connecting the plurality of connection members and the plurality of link lines, and the plurality of connection members may be disposed on the step portions.

End portions of the plurality of link lines may be disposed on the same plane as an end portion of the support substrate on the other side of the support substrate.

The display device may further include an end protection member covering the end portions of the plurality of link lines and the end portion of the support substrate.

The display device may further comprise a plurality of anti-corrosion patterns disposed on the support substrate to cover the plurality of link lines.

The plurality of anti-corrosion patterns may be formed of indium tin oxide (ITO).

The display device may further comprise a filling member disposed between the support substrate and the plurality of display modules, wherein a refractive index of the filling member may be identical to a refractive index of the support substrate.

All of the plurality of link lines may overlap the plurality of display modules.

One portion of the plurality of link lines may overlap the plurality of display modules, and another portion of the plurality of link lines may be exposed by the plurality of display modules. The other portion of the plurality of link lines may be covered by an insulating layer.

Each of the plurality of display modules may further comprise: a substrate including transmissive areas; a plurality of planarization layers disposed on the substrate; a plurality of light emitting elements disposed on the substrate; and a bank disposed on the substrate, wherein the plurality of planarization layers and the bank may be disposed in an area excluding the transmissive area.

Each of the plurality of display modules may further comprise a plurality of reflective layers in which they overlap the plurality of light emitting elements, wherein the plurality of reflective layers may be disposed in an area excluding the transmissive area.

Each of the plurality of display modules may further comprise: a first electrode disposed on the plurality of planarization layers; and a second electrode disposed on the plurality of planarization layers, wherein the first electrode and the second electrode may electrically connect the plurality of signal lines and the plurality of light emitting elements.

The first electrode and the second electrode may be electrically connected to the plurality of light emitting elements through the plurality of via holes disposed in the plurality of planarization layers.

Although the exemplary embodiments of the present disclosure have been described in detail with reference to the accompanying drawings, the present disclosure is not limited thereto and may be embodied in many different forms without departing from the present disclosure. The protective scope of the present disclosure should be construed based on the following claims.

## Claims

1. A display device (100), comprising:
a support substrate (121);
a plurality of link lines (LL) disposed on the support substrate (121);
a plurality of first flexible films (161) disposed on one side of the support substrate (121) and electrically connected to the plurality of link lines (LL);
a plurality of display modules (110) disposed on or under the support substrate (121) and including a plurality of pixels (P) and a plurality of signal lines; and
a plurality of connection members (190) disposed between the support substrate (121) and the plurality of display modules (110) and electrically connecting the plurality of link lines (LL) and the plurality of signal lines.

2. The display device (100) of claim 1, further comprising: a plurality of second flexible films (162) disposed on the other side of the support substrate (121).

3. The display device (100) of claim 2, wherein each of the plurality of link lines (LL) is electrically connected to one of the plurality of first flexible films (161) and one of the plurality of second flexible films (162).

4. The display device (100) of any of claims 1 to 3, wherein the plurality of connection members (190) are electrically connected to the plurality of signal lines in an area where they overlap outermost pixels (P) among the plurality of pixels (P).

5. The display device (100) of any of claims 1 to 3, wherein the plurality of connection members (190) are electrically connected to the plurality of signal lines in an area in which they overlap some pixels (P) among the plurality of pixels (P) of the display modules (110).

6. The display device (100) of any of claims 1 to 3, wherein the plurality of connection members (190) are electrically connected to the plurality of signal lines in an area where they randomly overlap some pixels (P) among the plurality of pixels (P).

7. The display device (100) of any of claims 1 to 6, wherein the plurality of display modules (110) are disposed on the support substrate (121),
the plurality of display modules (110) include a plurality of via holes (VIA), and
the plurality of connection members (190) are disposed in the plurality of via holes (VIA) and are in contact with the plurality of link lines (LL) and the plurality of signal lines.

8. The display device (900) of any of claims 1 to 6, wherein the support substrate (921) is disposed on the plurality of display modules (910),
the plurality of display modules (910) include step portions (980) for connecting the plurality of connection members (990) and the plurality of link lines (LL), and
the plurality of connection members (990) are disposed on the step portions (980).

9. The display device (1100) of any of claims 1 to 8, wherein end portions of the plurality of link lines (LL) are disposed on the same plane as an end portion of the support substrate (1121) on the other side of the support substrate (1121).

10. The display device (1100) of claim 9, further comprising: an end protection member (1151) covering the end portions of the plurality of link lines (LL) and the end portion of the support substrate (1121).

11. The display device (1300) of any of claims 1 to 10, further comprising: a plurality of anti-corrosion patterns (1352) disposed on the support substrate (121) to cover the plurality of link lines (LL).

12. The display device (1300) of claim 11, wherein the plurality of anti-corrosion patterns (1352) are formed of indium tin oxide.

13. The display device (100) of any of claims 1 to 12, further comprising: a filling member (124) disposed between the support substrate (121) and the plurality of display modules (110),
wherein a refractive index of the filling member (124) is identical to a refractive index of the support substrate (121).

14. The display device (100) of any of claims 1 to 13, wherein all of the plurality of link lines (LL) overlap the plurality of display modules (110).

15. The display device (100) of any of claims 1 to 13, wherein one portion of the plurality of link lines (LL) overlaps the plurality of display modules (110), and the other portion of the plurality of link lines (LL) is exposed by the plurality of display modules (110), and
the other portion of the plurality of link lines (LL) is covered by an insulating layer.

16. The display device of claim 1,
wherein each of the plurality of display modules(110) further comprises:
a substrate (101) including transmissive areas(TA);
a plurality of planarization layers (115a,115b) disposed on the substrate (101);
a plurality of light emitting elements (LED) disposed on the substrate(101); and
a bank (119) disposed on the substrate (101),
wherein the plurality of planarization layers (115a,115b) and the bank (119) are disposed in an area excluding the transmissive area (TA).

17. The display device of claim 16, wherein each of the plurality of display modules (110) further comprises a plurality of reflective layers (117) in which they overlap the plurality of light emitting elements (LED),
wherein the plurality of reflective layers (117) are disposed in an area excluding the transmissive area (TA).

18. The display device of claim 16, wherein each of the plurality of display modules (110) further comprises:
a first electrode (CE1) disposed on the plurality of planarization layers (115a,115b); and
a second electrode (CE2) disposed on the plurality of planarization layers (115a,115b),
wherein the first electrode (CE1) and the second electrode (CE2) electrically connect the plurality of signal lines and the plurality of light emitting elements (LED).

19. The display device of claim 18, wherein the first electrode (CE1) and the second electrode (CE2) are electrically connected to the plurality of light emitting elements (LED) through the plurality of via holes (VIA) disposed in the plurality of planarization layers (115a,115b).
